# EUROPEAN PATENT SPECIFICATION

(11) **EP 4 576 091 B1**
(45) Date of publication and mention of the grant of the patent: **23.09.2026**
(21) Application number: 23220097.2
(22) Date of filing: 22.12.2023
(51) Int. Cl.: G11C 11/16, G11C 13/00

(54) **CROSS POINT MEMORY DEVICE**
KREUZPUNKTSPEICHERVORRICHTUNG
DISPOSITIF DE MÉMOIRE À POINTS DE CROISEMENT

(43) Date of publication of application: 25.06.2025
(73) Proprietor: IMEC VZW, 3001 Leuven (BE); Katholieke Universiteit Leuven, 3000 Leuven (BE)
(72) Inventor: RAVSHER, Taras, 3001 Heverlee (BE); FANTINI, Andrea, 3001 Heverlee (BE)
(74) Representative: Lind Edlund Kenamets Intellectual Property AB

(56) References cited:
- US-A1- 2008 025 076
- RICHARD DORRANCE ET AL: "Diode-MTJ Crossbar Memory Cell Using Voltage-Induced Unipolar Switching for High-Density MRAM", IEEE ELECTRON DEVICE LETTERS, IEEE, USA, vol. 34, no. 6, 1 June 2013 (2013-06-01), pages 753 - 755, XP011510831, ISSN: 0741-3106, DOI: 10.1109/LED.2013.2255096

## Description

### TECHNICAL FIELD

The present invention generally relates to a cross point memory device.

### BACKGROUND

A cross point memory array comprises a plurality of parallel word lines and a plurality parallel of bit lines arranged to extend over and across each other to define an array of cross points. A resistive memory element, such as a phase-change memory (PCM), a magnetic tunnel junction (MTJ) with voltage-controlled magnetic anisotropy (VCMA), or other unipolar memory element, may be connected between the word lines and bit lines at each cross point to realize a dense array of memory cells with a small area footprint.

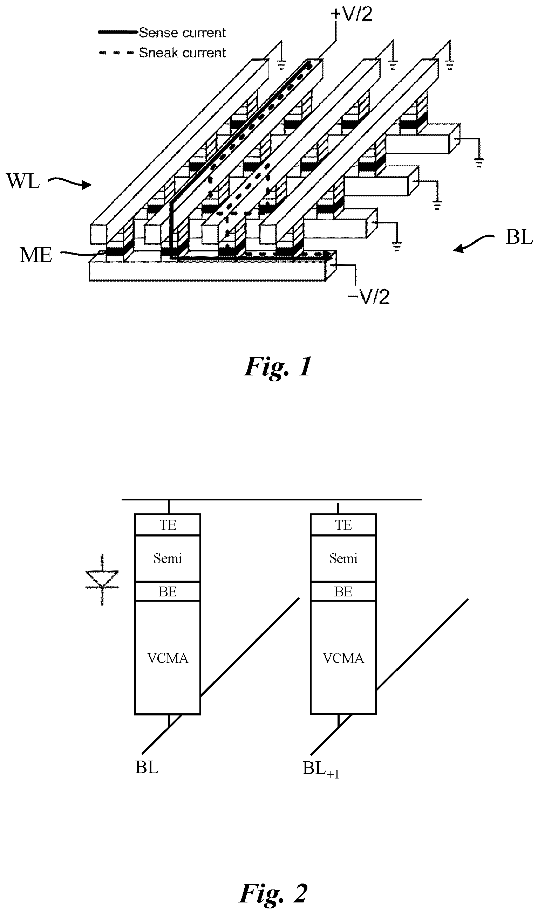

However, a notable drawback with such a cross point memory array is the significant leakage currents arising through half-selected memory cells during write and read operations. This is illustrated in Fig. 1, including a schematic depiction of a cross point memory array comprising word lines WL and bit lines BL and a memory element at each cross point. The solid line path indicates a sense current and the dashed line path indicates sneak currents through non-selected memory cells.

In order to suppress these so-called sneak currents, a highly non-linear two-terminal selector device may be stacked and connected in series with the resistive memory element at each cross point, to define a 1D1R memory cell (D - diode, R - resistive memory element) at each cross point. In the case of unipolar memory technologies (such as PCM or VCMA-MTJs), a Schottky diode is typically considered a good and rational choice. Fig. 2 schematically shows an example of two 1D1R memory cells at neighboring cross points between a word line WL and two bit lines BL and BL₊₁, each comprising a Schottky diode as selector device stacked on top of a VCMA-MTJ memory element. The document "Diode-MTJ Crossbar Memory Cell Using Voltage-Induced Unipolar Switching for High-Density MRAM" by RICHARD DORRANCE ET AL ,IEEE ELECTRON DEVICE LETTERS, IEEE, USA, vol. 34, no. 6, 1 June 2013 (2013-06-01), pages 753-755, discloses a diode-MTJ MeRAM crossbar array.

While the use of a Schottky diode removes the need for a select transistor in each memory cell (which would come with a considerable area penalty), a challenge with the 1D1R memory cell is the loss of read margin (e.g. tunneling magnetoresistance ratio (TMR) in the case of VCMA). The reduced read margin may be attributed to the voltage drop across the Schottky diode selector device which will tend to affect the sense current through the memory cell differently depending on the resistance state, and thus reduce the effective resistance ratio of the high and low resistance states of the memory element.

There is hence a need for an improved design of a cross point memory device building on the area benefits and small leakage currents enabled by the 1D1R, but avoiding or mitigating read margin degradation.

### SUMMARY

It is an object of the present invention to address at least some of the issues mentioned above. Thus, it is an object to the above provide a 1D1R-based cross point memory device of an improved design reducing or limiting read margin degradation.

Hence, according to a first aspect of the present invention, there is provided a cross point memory device comprising:
first access lines and second access lines, the first access lines extending in a first direction and the second access lines extending in a second direction across the first direction to define a plurality of cross points between the first and second access lines; and
a memory cell connected between the first access line and the second access line at each cross point and comprising a resistive memory element switchable between a first resistance state and a second resistance state;
wherein each first access line comprises a metal layer and a semiconductor layer extending continuously in the first direction to define a distributed Schottky diode forming a respective selector device of each memory cell, wherein the selector device and the resistive memory element of each memory cell are connected in series between the associated first and second access lines via an internal node of the respective memory cell; and
wherein the internal nodes of each pair of consecutive memory cells along each respective first access line are connected by a respective segment of the semiconductor layer defining a semiconductor channel configured to be gated by the metal layer of its associated first access line;
the memory device further comprising read circuitry configured to read the resistive memory element of a selected memory cell connected to a selected first access line and a selected second access line by: applying a select voltage to the metal layer of the selected first access line, a reference voltage to the selected second access line, a first un-select voltage to the metal layer of the non-selected first access lines, and a second un-select voltage to non-selected second access lines,
wherein the select voltage, the reference voltage and the first and second un-select voltages are set such that:
   the selector device of the selected memory cell is forward biased with a voltage exceeding a threshold voltage of the selector device,
   the selector devices of non-selected memory cells are either forward biased with a sub-threshold voltage, substantially zero-biased, or reverse biased, and
   a biasing current flows into the internal node of the selected memory cell from the non-selected second access lines, via the semiconductor channels connected to the selected memory cell.

The cross point memory device of the first aspect is based on the idea that by extending the semiconductor layer of the Schottky diode selector of each memory cell (which conventionally is separate for each memory cell) along the length of each first access line, each first access line may provide a double function of both defining a separate Schottky diode selector for each memory cell along the first access line, as well as defining a respective metal-semiconductor field-effect transistor, MESFET, with a lateral semiconductor channel, interconnecting the internal nodes of each pair of consecutive memory cells along the first access line, and having a variable resistance controllable by the voltage applied to the first access line (more specifically the voltage applied to the associated gate/metal line of the first access line).

While the diode selectors of the memory cells facilitate selective read and suppressed sneak currents, the lateral semiconductor channels of the MESFETs enables providing a controllable biasing current to the internal node of a selected memory cell to compensate for the voltage drop across the selector device and thus increase the difference between the sense currents obtained for high and low resistance states of the memory element . The select voltage applied to the metal line of the selected first access line will hence both be used as a select voltage for the selector device of the selected memory cell, and as a gate voltage for the MESFETs along the selected first access line.

Since the selector device of the selected memory cell is forward biased with a voltage exceeding a threshold voltage of the selector device, a sense current (interchangeably read current) may be conducted through the selected first access line, into and through the memory cell. The total current through the selected memory cell will be the sum of the biasing current from the non-selected second access lines received via the MESFET channels and the sense current from the selected first access line received via the selector device of the selected memory cell. Thus, even a small resistance (and hence voltage) difference between the resistive states of the resistive memory element may be amplified due to the internal gain of the selected memory cell.

The semiconductor channels defined along the respective first access lines may typically present a channel resistance which decreases with increasing gate voltage. The term "gate voltage" here refers to the voltage between the metal layer configured to gate the respective lateral semiconductor channel and either of the interconnected pair of internal nodes. With reference to the selected memory cell, the gate voltage may more specifically refer to the voltage between the metal layer of the selected first access line and the internal node of the selected memory cell. In view of the preceding discussion of the MESFETs, the first access lines may define n-channel type MESFETs wherein the internal node of the selected memory cell may act as a source for the MESFETs connected thereto.

Since the selector devices of the non-selected memory cells are either forward biased with a sub-threshold voltage, substantially zero-biased, or reverse biased, sneak currents through the selector devices of the non-selected memory cells may be efficiently suppressed.

Accordingly, with a proper selection of the select voltage, the reference voltage and the first and second un-select voltages, the cross point memory device of the first aspect may provide the sneak current suppression associated with conventional 1D1R memory cells, and at a same time avoid or mitigate the read margin degradation which otherwise is associated with such memory cells. In fact, as may be appreciated from the following, the memory device even enables achieving an amplification of the read margin above the resistance ratio the resistive memory element of a 1R memory cell would provide.

As the biasing current is supplied via the neighboring non-selected memory cells along the selected first access line, and the MESFETs are integrally formed with the first access lines, the above-mentioned technical effects may be provided without any increase in area footprint.

Furthermore, from a manufacturability point of view, it is noted that the conventional 1D1R cell may encounter material-related scaling issues, due to the need to etch the Schottky diode stack. For instance, a semiconductor layer such as InGaZnO (IGZO) may suffer from etch-induced sidewall damage that results in increased reverse leakage current. This issue becomes especially pronounced for aggressively scaled dimensions, where perimeter contribution can easily overwhelm the normal area-dependent diode current. In this respect, the distributed Schottky diode configuration of the memory device of the present aspect may be beneficial, since the resulting diode structure is confined only in direction. This can significantly improve overall diode characteristics, without compromising area footprint. In a sense, the distributed Schottky diode selector may be useful for certain semiconductor materials (e.g. oxide semiconductors such as IGZO), even without the added benefit of read margin amplification.

By the term "internal node" of a memory cell is here meant a circuit node between or common to the selector device and the memory element of the memory cell. The internal node may for instance correspond to an electrode of the memory element arranged in ohmic contact with the semiconductor layer of the respective Schottky diode selector.

By the term "selected", as in "a selected memory cell" is here meant any one of the memory cells of the memory device which during a read operation (or write operation as set out below) is selected for reading (or writing). Accordingly, the "selected" first and second access lines correspond to the respective first and second access lines, among the plurality of first and second access lines, which are connected to the selected memory cell, i.e. the memory cell selected for reading (or writing).

By the term "reference voltage" is here meant a voltage with respect to which the select and un-select voltages are defined. The reference voltage may typically correspond to a ground reference voltage (GND, i.e., approximately 0 V) but may more generally correspond to a low-level supply voltage (e.g. VSS).

By the term "resistive memory element" is here meant any conventional type of memory element being switchable between a high resistance state and a low resistance state, for instance a unipolar resistive memory element such as a voltage-controlled magnetic anisotropy (VCMA) resistive memory element or a phase change memory element.

In some embodiments, a gate threshold voltage of each lateral semiconductor channel is lower than the threshold voltage of the selector devices, wherein the select voltage, the reference voltage and the first and second un-select voltages are set such that a gate voltage for the lateral semiconductor channels along the selected first access line exceeds the gate threshold voltage and such that a gate voltage for the lateral semiconductor channels along the non-selected first access lines is less than the gate threshold voltage.

By a "gate threshold voltage" of a lateral semiconductor channel is here meant the minimum gate voltage that is needed to form a lateral conducting channel between the interconnect internal nodes. The selector devices of the non-selected memory cells along the selected first access line will be forward biased with a sub-threshold voltage, substantially zero-biased, or reverse biased when the MESFETs defined along the selected first access line are switched on. Meanwhile, the MESFETs along the non-selected first access lines may be switched off to efficiently suppress lateral sneak currents between memory cells along the non-selected first access lines.

In some embodiments, the first resistance state and the second resistance state of the resistive memory elements are respectively associated with a first resistance and a second resistance exceeding the first resistance, and wherein, responsive to the select voltage, the reference voltage, the first un-select voltage and the second un-select voltage being applied to the first and second access lines by the read circuitry during reading of the selected memory cell, each lateral semiconductor channel connected to the internal node of the selected memory cell presents a first channel resistance exceeding the second resistance of the second resistance state, and a channel resistance of each other lateral semiconductor channel along the selected first access line exceeds the first channel resistance.

The semiconductor channels defined along the respective first access lines may accordingly present a channel resistance depending on the associated gate voltage, such that the select and un-select voltages applied by the read circuitry during reading results in a lower channel resistance in the lateral semiconductor channels connected to the selected memory cell than in the other lateral semiconductor channels along the selected first access line. Lateral current conduction into internal nodes of non-selected memory cells may hence be limited reduced.

In some embodiments, the first channel resistance is at least 2 times the second resistance of the second resistance state of the resistive memory element. Thereby, a risk of disturbing the non-selected memory cells neighboring the selected memory cell (which accordingly supply the biasing current) may be mitigated. Further, the effect of the (variable) resistance of the memory elements of the non-selected neighboring memory cells on the biasing current may be limited.

In embodiments wherein the lateral semiconductor channels are configured present a distinct threshold voltage (as set out above), the first channel resistance may be defined by an on-state resistance of the lateral semiconductor channels. Correspondingly, the channel resistance of the other lateral semiconductor channels may be defined by an off-state resistance. "On-state resistance" and "off-state resistance" here refers to a respective resistance (or resistance value) of the respective lateral semiconductor channels when the gate voltage exceeds the threshold voltage and when the gate voltage is less than threshold voltage, respectively. The "off-state resistance" may in particular refer to the resistance of the respective lateral semiconductor channels when the gate voltage is less than the threshold voltage by an amount such that sub-threshold leakage is substantially zero. As the biasing conditions of the non-selected memory cells along the selected and non-selected second access lines may differ, it is to be understood that the off-state resistance may vary among the lateral semiconductor channels.

In some embodiments, the second un-select voltage corresponds to, or is greater than, the select voltage. This enables substantially zero-biasing or reverse-biasing of the non-selected selector devices. More specifically, if the second un-select voltage corresponds to the select voltage, the non-selected selector devices along the selected first access line may be substantially zero-biased. Meanwhile, the non-selected selector devices along the non-selected first access lines may be reverse-biased (under the reasonable assumption that the first un-select voltage does not exceed the select voltage). On the other hand, if the second un-select voltage is greater than the select voltage (and assuming this applies also with respect to the first un-select voltage), the non-selected selector devices may all be reverse-biased. This may further be useful to avoid or minimize sub-threshold leakage through the MESFETs, in cases where the MESFETs are not fully turned off at zero gate bias. That is, the second un-select voltage may exceed the select voltage by an amount such that a sub-threshold leakage through the lateral semiconductor channels is substantially zero.

By a voltage (such as the second un-select voltage) "corresponding to" another voltage (such as the select voltage) is hereby meant that the voltages substantially match or are substantially equal. That is, "corresponding" voltages means that the voltages need not necessarily be exactly equal to each other, but may differ to each other to some degree. Such differences may for instance at least in part be attributed to Process-Voltage-Temperature (PVT) variations. For instance, "corresponding" voltages may differ from each other by at most 10%, at most 5% or at most 2%. Voltages with a difference within these ranges may thus be considered as "corresponding" (i.e., substantially matching or be substantially equal) as these differences will be sufficiently small to not fundamentally alter the read and (and write) operations of the memory device.

In some embodiments, the first un-select voltage corresponds to or is lower than the reference voltage. By biasing the metal layers of the un-selected first access lines, a lateral resistance of the lateral semiconductor channels between non-selected memory cells may be further increased to further mitigate sneak currents. Assuming the reference voltage corresponds to ground, the first un-select voltage may accordingly be a negative voltage.

The provision of the distributed Schottky diode and MESFETs integrally formed with the first access lines further allows implementing selective programming of individual memory cells with a biasing scheme similar to the biasing scheme during read, with efficient sneak current suppression through non-selected memory cells.

Accordingly, in some embodiments the memory device further comprises write circuitry configured to program a resistance state of the resistive memory element of a memory cell selected for write (hereinafter referred to as "second selected memory cell") by: applying a write voltage to the respective first access line connected to the second selected memory cell, a reference voltage to the respective second access line connected to the second selected memory cell, a first write un-select voltage to non-selected first access lines and a second write un-select voltage non-selected second access lines (i.e. first and second access lines not connected to the second selected memory cell),
wherein the write voltage, the reference voltage and the first and second write un-select voltages are set such that: the selector device of said memory cell selected for write is forward biased with a voltage exceeding the threshold voltage of the selector device, the resistive memory element of said memory cell is biased with a voltage exceeding a resistive state switching threshold voltage of the resistive memory element, and the selector devices of non-selected memory cells are either forward biased with a sub-threshold voltage, substantially zero-biased, or reverse biased.

Thereby a selective programming of the resistive memory element of the second selected memory may be provided while limiting sneak currents through non-selected memory cells, which may tend to reduce the power efficiency of the write operation.

In view of the above discussion of the meaning of the term "selected memory cell", it is to be understood that the label "second" in "second selected memory cell" merely is a label introduced to facilitate referencing the memory cell selected for write. That is, the "second selected memory cell" may be any one of the memory cells of the cross point memory device, i.e. a different memory cell than the above-discussed "selected memory cell" referenced in the discussion of the read operation (which correspondingly may be referred to as "first selected memory cell") or same memory cell as the first selected memory cell.

The reference voltage applied to the second access line connected to the second selected memory cell may typically (but is not limited to) be a same reference voltage as applied to the selected second access line connected to the first selected memory cell during read. This may reduce the complexity of the read and write schemes, and the number of bias generators needed to generate the various voltages of the read and write schemes.

By specifically setting the second write un-select voltage to correspond to the write voltage, the selector devices of the non-selected memory cells connected to the same first access line as the second selected memory cell may be substantially zero-biased, thus suppressing leakage currents therethrough.

In some embodiments, the first write un-select voltage corresponds to or is lower than the reference voltage. In light of the above discussion concerning the effect on gate voltage on the lateral channel resistance, it may be appreciated that a first write un-selected voltage corresponding to or being lower than the reference voltage enables an increased channel resistance, and hence a suppressed leakage.

In some embodiments, each segment of the semiconductor layer extends between a pair of electrode contact portions of the semiconductor layer, each electrode contact portions making Ohmic contact with an electrode of a respective resistive memory device, wherein a thickness dimension of the electrode contact portions exceeds a thickness dimension of the segments.

Varying a thickness dimension of the semiconductor layer along the length of the first access lines such that the local thickness of the semiconductor layer at the diode selector of each memory cell is greater than the local thickness along the segments, allows optimizing the diode selectors and the lateral semiconductor channels of the MESFETs separately. Thereby an off-state leakage of the selector devices may be effectively suppressed, while the on-state current of the selector devices remains substantially unaffected and the lateral channel thickness (and hence channel resistance) may be kept constant.

In some embodiments, each segment of the semiconductor layer of each first access line extends between a pair of electrode contact portions of the semiconductor layer, each electrode contact portions making Ohmic contact with an electrode of a respective resistive memory device, wherein a doping concentration of the segments is lower than a doping concentration of the electrode portions. Hence, the channel resistance of the lateral semiconductor channels of the MESFETs may be increased without reducing an on-state current of the selector devices.

In some embodiments, the semiconductor layer of each first access line comprises an oxide semiconductor-layer. Oxide semiconductors enable back-end-of-line compatible implementations and exist in many compositions with mobilities suitable for supplying lateral biasing currents between the memory cells as set out above. One suitable example is a layer of InGaZnO (IGZO).

In some embodiments, the metal layer of the first access lines comprises a continuous first metal sub-layer and a continuous second metal sub-layer of a work function metal arranged between the first metal sub-layer and the semiconductor layer and defining the distributed Schottky diode together with the semiconductor layer. Hence, a metal layer with a suitable work function may be provided in Schottky contact with the semiconductor layer, while a separate lower resistance metal may be provided for lowering a resistance of the first access lines.

### BRIEF DESCRIPTION OF THE DRAWINGS

This and other aspects of the present invention will now be described in more detail, with reference to the appended drawings showing embodiments of the present invention.
Fig. 1 is a schematic perspective view of a conventional cross point memory array.
Fig. 2 is a schematic illustration of conventional 1D1R memory cells.
Fig. 3a-c show, respectively, a circuit diagram of a conventional 1D1R memory cell, a graphical bias-point analysis for the 1D1R memory cell for two resistive memory element states, and a resulting estimated TMR degradation due to the voltage drop across the selector diode.
Fig. 4 is a schematic perspective view of a cross point memory device according to an embodiment.
Fig. 5 is a representative schematic detail view of a section along a first access line of the cross point memory device of Fig. 4.
Fig. 6 show simulations of a drain-to-source current through a MESFET defined along the first access line and a diode selector current as a function of gate-to-source voltage applied to the metal layer of the first access line.
Fig. 7 is a circuit diagram showing the flow of a biasing current into an internal node of a selected memory cell during read.
Fig. 8 is a simplified circuit diagram illustrating the effect of supplying a biasing current to an internal node of a memory cell.
Fig. 9 shows a simulation of currents through a selected memory cell and its five nearest neighbouring memory cells along the selected first access line for an example read biasing scheme.
Fig. 10 is a schematic perspective view of a cross point memory device according to an embodiment during write mode.

### DETAILED DESCRIPTION

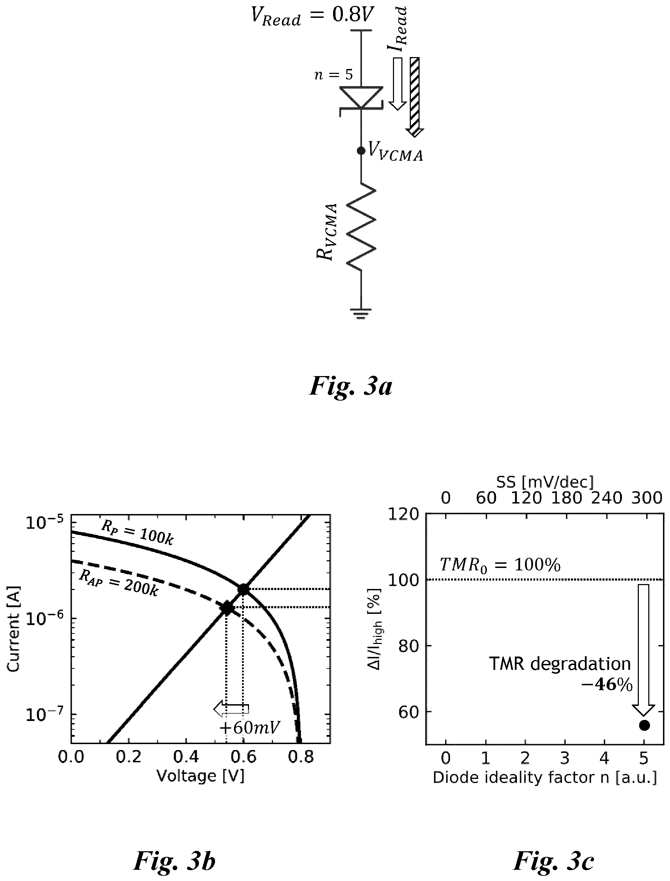

Fig. 3a is a circuit diagram of a conventional 1D1R memory cell. In the depicted example the resistive memory element (hereinafter abbreviated ME) is a magnetic tunnel junction (MTJ) with a voltage-controlled magnetic anisotropy (VCMA) which means that the ME may be switched between a lower resistance state P and a higher resistance state AP. The following description is however equally applicable to any other unipolar ME switchable between low and high resistance states, such as PCM-based ME. For simplicity the resistance R_{VMCA} of the example ME is assumed to be 100 kΩ in the low resistance state and 200 kΩ in the higher resistance state, which translates to a resistance ratio (equivalent to the TMR for an MTJ) of 100%. However, upon reading the 1D1R cell, the effective resistance ratio will become considerably smaller than this inherent resistance ratio because of the additional voltage drop across the diode selector. In Fig. 3a, the arrow without fill pattern indicates the magnitude of the sense current *I_{Read}* for the high resistance state (where *I_{Read}* is about 1.3 µA) and the arrow with diagonal hatching indicates the magnitude of the sense current *I_{Read}* for the low resistance state (where *I_{Read}* is about 2.0 µA). As illustrated in the bias-point analysis of Fig. 3b, the drop in read margin can be rather substantial. For instance, assuming a selector diode with an assumed diode ideality factor of n=5, the voltage shift between the low and high resistance states may be as small as 60 mV, assuming a read voltage of 0.8 V. Hence, instead of the initial resistance ratio of 100%, the effective resistance ratio is reduced by 46%. More specifically, this voltage shift corresponds to the additional voltage drop across the diode selector when the ME is switched from the high resistance state (200 kΩ) to the low resistance state (100 kΩ), wherein the voltage across the ME is effectively reduced (since the total 1D1R voltage is kept constant at 0.8V). Hence, the current through 1D1R will be smaller than the expected doubling. While a smaller diode ideality factor n reduces the drop in resistance ratio, this effect is present even for an ideal diode (n=1).

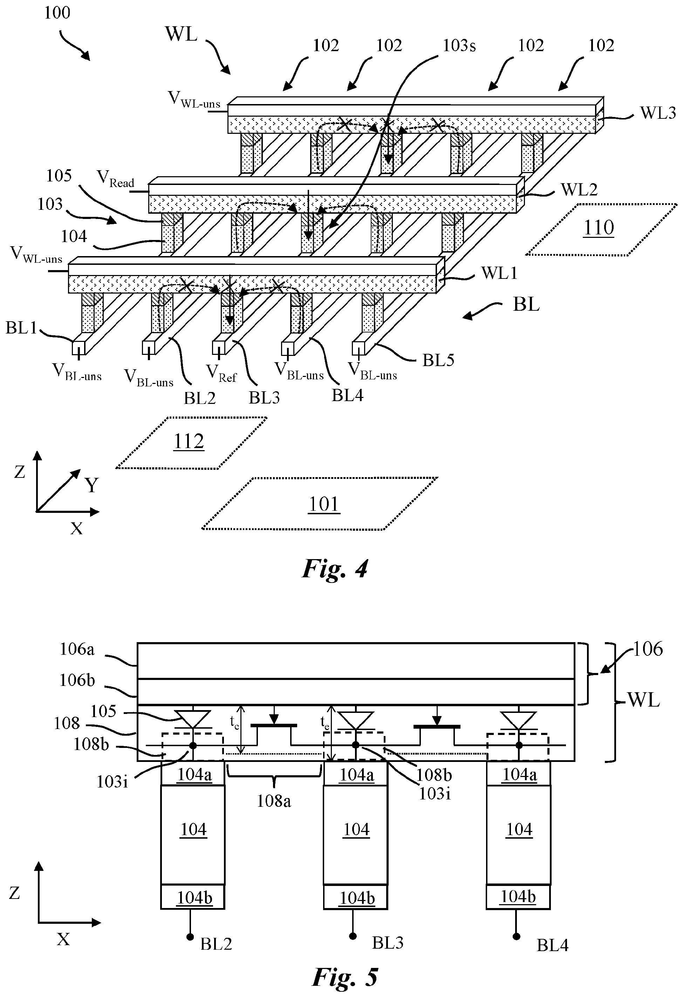

Fig. 4 is a schematic perspective view of a cross point memory device 100 according to an embodiment with a design aiming to mitigate the read margin degradation illustrated in Fig. 3a-c.

The cross point memory device is a memory device comprising a cross point array. The cross point array of the memory device 100 comprises as depicted a plurality of first access lines WL extending in parallel in a first direction X, and being spaced apart (e.g. equidistantly) along a second direction Y transverse to the first direction X. As shown, the first and second directions X, Y define respective horizontal directions, wherein "horizontal" denotes that the directions are parallel to a plane of extension of a substrate 101 of the memory device 100. The array further comprises a plurality of second access lines BL extending in parallel in the second direction Y. A plurality of cross points are hence defined between the first and second access lines WL, BL, each cross point defined at a crossing between a respective first access line and a respective second access line. The first and second access lines may as indicated by their respective designation "WL" and "BL" in Fig. 4 define word lines and bit lines of the cross point array. Fig. 4 only shows a small number of first access lines WL1, WL2, WL3 and second access lines BL1, BL2, BL3, BL4, BL5, however the memory device 100 may typically comprise a considerably larger number of first and second access lines.

The memory device 100 further comprises a respective memory cell 103 arranged at each cross point and connected between the first access line WL and the second access line BL at the cross point 102. As is more clearly shown in the detail view of Fig. 5, showing a section of a first access line WL representative for any of the first access lines WL1-WL3 shown in Fig. 3, each memory cell 103 comprises a resistive memory element (ME) 104. The ME 104 is switchable between a first resistance state and a second resistance state. The ME 104 may for instance be a unipolar resistive memory element, such as a VCMA-based ME or a PCM-based ME.

Each memory cell 103 further comprises a respective Schottky diode selector 105, connected in series with the ME 104 of the memory cell 104, between the associated first and second access lines WL, BL. Each memory cell 103 is hence a 1D1R cell. In contrast to the implementation of such memory cells, the respective diode selectors along each respective first access line WL in contrast forms part of a distributed Schottky diode selector memory device 100. As shown, in Fig. 5, each first access line WL comprises a metal layer 106 and a semiconductor layer 108 extending continuously in the first direction X to define a distributed Schottky diode forming a respective selector device 105 of each memory cell 103. The selector device 105 and the ME 104 of each memory cell 103 are connected in series between the associated first and second access lines WL, BL via an internal node 103i of the respective memory cell 103. Moreover, the internal nodes 103i of each pair of consecutive memory cells 103 along each respective first access line WL are connected by a respective segment 108a of the semiconductor layer 108. The segment 108a defines a lateral semiconductor channel (in the following also designated by reference sign 108a) configured to be gated by the associated metal layer 106 of the first access line WL. Hence, as illustrated in Fig. 5, the first access line WL comprises a plurality of MESFETs, integrally formed with the first access line WL and comprising a lateral semiconductor channel 108a formed by a segment of the semiconductor layer 108, and a gate formed by the metal layer 106 of the first access line WL. The internal nodes 103i of each consecutive pair of memory cells 103 along the first access line WL are interconnected by the lateral semiconductor channel 108a of a respective one of the MESFETs.

Each segment and channel 108a shown may extend between a pair of electrode contact portions 108b of the semiconductor layer 108 (schematically indicated by dashed-line regions). Each electrode contact portion 108b makes Ohmic contact with an electrode 104a (which in the illustrated example is a top electrode) of a respective ME 104. The pair of electrode contact portions 108b may define the source and the drain for a respective MESFET. In the schematic depiction of Fig. 5, the internal nodes 103i are indicated to be located at a distance from the top electrode 104a of the respective MEs 104, within the electrode contact portions 108b. However, as may be appreciated this location is somewhat arbitrary and may just as well be considered to be collocated with the top electrode 104a.

Using a proper biasing scheme, the selector devices 105 of the memory cells 103 allow selective read and suppressed sneak currents. Meanwhile, as will be further described below, the lateral semiconductor channels 108a of the MESFETs interconnecting the memory elements 103 enables providing a controllable biasing current to the internal node 103i of a selected memory cell 103s during read operation, to compensate for the voltage drop across the selector device 105 and thus increase a total current through the memory element 104 of the selected memory cell 103s. The select voltage applied to the metal line 106 of the selected first access line WL will hence both be used as a select voltage for the selector device 105 of the selected memory cell 103s, and as a gate voltage for the MESFETs along the selected first access line WL.

The semiconductor layers 108 of the first access lines WL may typically be n-type semiconductor layers, wherein the lateral semiconductor channels 108a may define n-type semiconductor channels. The MESFETs will in the following be assumed to comprise an n-type lateral semiconductor channel 108a having a channel resistance which decreases with increasing gate voltage. The MESFETs may be configured to operate in either enhancement-mode (implying a threshold voltage of about 0 V or greater) or depletion-mode (implying a threshold voltage below 0 V). The semiconductor layer 108 may comprises an oxide semiconductor-layer. Non-limiting examples include a layer of InGaZnO (IGZO), ZnO, InWO, InSnO or GaZnO. The thickness of the semiconductor layer 108 may be chosen in view of the target biasing conditions, on state current, off state current, etc.

The metal layer 106 may as shown in Fig. 5 comprise a stack of a first metal sub-layer 106a and a continuous second metal sub-layer 106b of a work function metal (WFM) arranged between the first metal sub-layer 106a and the semiconductor layer 108 and defining the distributed Schottky diode together with the semiconductor layer 108. The second metal sub-layer 106b may be formed of a metal with a suitably work function (e.g. higher than the electron affinity of the semiconductor layer 108), to obtain a desired Schottky barrier height. For an IGZO-semiconductor layer 108, a non-limiting example for the second metal sub-layer 106b is Pt. The first metal sub-layer 106a may be chosen to enable a low resistance connection to the memory cells 103 along the first access lines WL. The first metal sub-layer 106a may be formed by one or more metals typically used for metal line interconnects in the back end of line, such as W, Al, Cu, etc. However, provided a WFM with both a suitable work function and sufficiently low resistance is found, a single metal layer composition of the metal layer 106 is also possible.

Optionally, a doping concentration of the semiconductor layer 108 may be varied along its length such that a doping concentration in the segments 108a is lower than a doping concentration in the electrode portions 108b. Thereby, the channel resistance of the semiconductor channels 108a of the MESFETs may be tuned without reducing an on-state current of the selector devices 105.

Fig. 5 further indicates an optional variation of the first access line WL, wherein a thickness dimension tₑ of the electrode contact portions 108b exceeds a thickness dimension t_{c} of the segments 108a. This design variation may be applied separately or in combination with a varying doping concentration, to allow optimizing the diode selectors and the lateral semiconductor channels of the MESFETs separately.

The cross point array, including the first and second access lines WL, BL and the memory cells 103 may be comprised in an interconnect structure of the memory device 100. The first and second access lines WL, BL may be arranged in respective interconnect levels (metallization levels) of the interconnect structure. In the illustrated example, the first access lines WL are arranged above the second access lines BL, however the opposite configuration is also possible. In that case, the memory cells 103 will accordingly be arranged on top of the first access lines WL, and the second metal sub-layer 106b will be formed on top of the first metal sub-layer 106a. Additionally, the selector device 105 will be connected to a bottom electrode 104b of the ME 104.

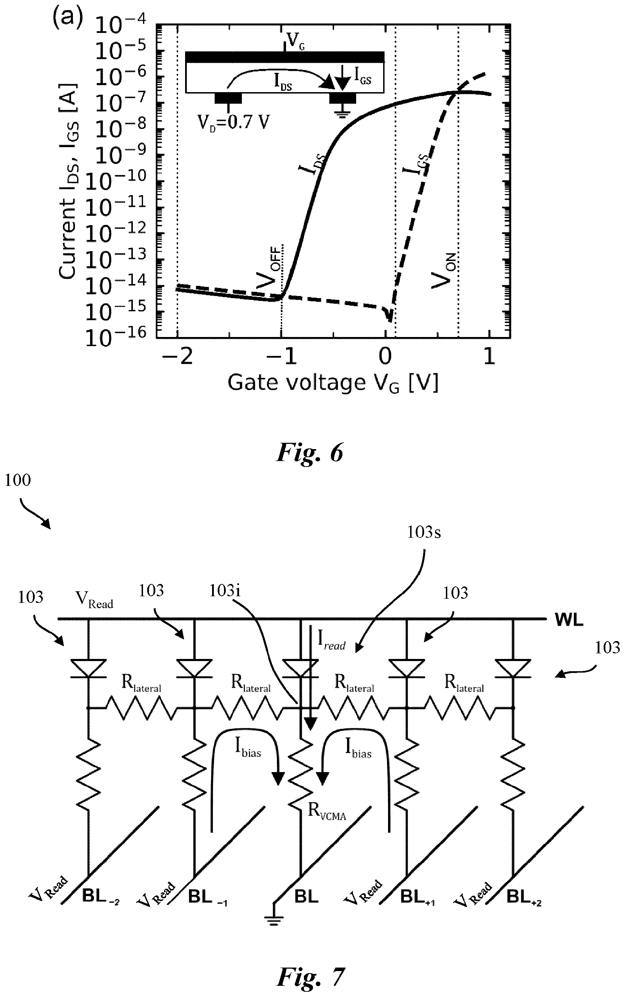

Fig. 6 shows a simulation of a drain-to-source current I_{DS} through the lateral semiconductor channel of a MESFET between a pair of consecutive memory elements along the first access line WL shown in Fig. 5 as a function of gate voltage Vg (i.e. gate-to-source voltage). Further shown is a simulation of the selector current (i.e. gate-to-source current) I_{GS} through the Schottky diode selector of one of the memory cells as a function of gate voltage. As may be seen, both the MESFET and the Schottky diode selector may present a respective distinct gate threshold voltage above which the drain-to-source current I_{DS} and the selector current, respectively, increases abruptly. In the illustrated simulation, the gate threshold voltage of the MESFET is a negative voltage and lower than the threshold voltage of the diode selector. However, in general, the specific value of the gate threshold voltage and the selector threshold voltage depend on parameters such as the doping concentration of the semiconductor layer, the thickness of the semiconductor layer, and the Schottky barrier height. In any case, Fig. 6 demonstrates that a first access line WL, with a configuration as shown in Fig. 5, may simultaneously define a MESFET and a Schottky diode selector with distinct respective threshold voltages separating their respective off- and on-states. However, the read and write operations as set out herein will work also if threshold voltages of the MESFETs and diode selectors are substantially equal.

Fig. 7 is a circuit diagram showing how the MESFETs of the first access line WL may be used to conduct a biasing current into an internal node of a selected memory cell 103s during read. The selected memory cell 103s is located at the cross point between the first access line WL and the second access line BL, which may correspond to any one of the first and second access lines shown in Fig. 4. The selected memory cell is biased by select voltage V_{read}. The non-selected memory cells are substantially zero-biased by applying the select voltage V_{read} also to the non-selected bit lines BL₋₁, BL₊₁, BL₋₂, BL₊₂. For simplicity, the MESFET circuit symbols are here replaced by resistor symbols where *Rₗₐᵣₑᵣₐₗ* denotes the channel resistance of the lateral semiconductor channels at the depicted biasing condition. Interconnecting consecutive internal nodes along the first access line WL. Assuming *Rₗₐₜₑᵣₐₗ* is reasonably large (e.g. comparable to or greater than the resistance of the ME 104) the total biasing current flowing into the internal node 103i will be dominated by the current sourced from the two nearest neighbouring bit lines, i.e. 2 * I_{bias}, as the resistance between farther bit lines and the internal node 103i will be significantly larger. This may further contribute to limit a lateral current flow between non-selected memory cells 103 along the selected first access line WL. Thus, the lateral semiconductor channels 103 may be configured to present a lateral channel resistance *Rₗₐₜₑᵣₐₗ* which is comparable to or exceeds the resistance of the high resistance state of the ME, both in an on-state and an off-state of the MESFETs. More specifically, denoting the resistance of the lateral semiconductor channel of a MESFET in an on-state by "first channel resistance" *R_{lateral,on},* and the resistance of the lateral semiconductor channel of the MESFET in an off-state by "second channel resistance" *R_{lateral,off},* each of the first channel resistance *R_{lareral,on}* and the second channel resistance *R_{lateral,off}* may exceed the resistance of the high resistance state of the ME, i.e. *R_{lareral,on}* > *R_{AP}* and *R_{lateral,off} > R_{AP}.* For example *R_{lareral,on}* and *R_{lareral,off} may* each be at least 2 times *R_{AP}.* On the other hand, provided the first channel resistance *R_{lareral,on}* is at most 15 times *R_{AP},* a sufficient biasing current may be provided for a practical range of read bias voltages. As a further example, a ratio of the first channel resistance *R_{lareral,on}* of the lateral semiconductor channel to the resistance *R_{VCMA}* of the ME may be in a range from 5-10, for either of *R_{VCMA}* = *R_{P}* or *R_{VCMA} = R_{AP}.* This may strike a reasonable balance between low read disturb and sufficient biasing current.

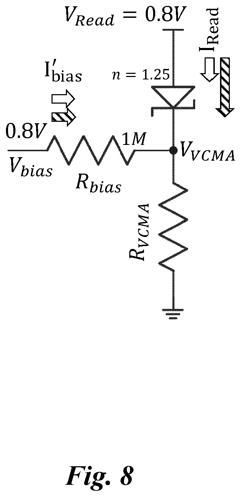

To facilitate understanding of the effect of supplying a biasing current to an internal node of a selected memory cell, reference is made to the Fig. 8, showing a circuit diagram of a memory cell simplified to consider only a single biasing current from one neighbouring memory element, as opposed to two as in Fig. 7. In the figure, the arrows without fill pattern indicates the magnitude of the sense current *I_{Read}* received from the access line and the bias current ${I}_{bias}^{′}$*,* respectively, for the high resistance state and the arrow with diagonal hatching indicates the magnitude of the sense current *I_{Read}* and the bias current ${I}_{bias}^{′}$*,* respectively, for the low resistance state.

From the circuit diagram it may be seen that the voltage *V_{VCMA}* at the internal node is given by: ${V}_{VCMA} = \frac{{R}_{VCMA}}{{R}_{VCMA} + {R}_{bias}} ⋅ {V}_{bias}$ where *R_{VCMA}* like before denotes the resistance of the ME (e.g. *R_{VCMA} = R_{AP}* or *R_{VCMA} = R_{P}*) and *V_{bias}* corresponds to the voltage at the internal node of the neighbouring memory element. This expression is an approximation valid in the regime when the current through the diode selector *I_{Read}* is small compared to the biasing current ${I}_{bias}^{′}$*.* The sense current *I_{Read}* is then given by: ${I}_{Read} = {I}_{0} exp \left(\frac{q \left({V}_{Read}-{V}_{VCMA}\right)}{nkT}\right)$

The effective resistance ratio is in turn proportional to: $TMR ∼ exp \left(qΔ{V}_{VCMA}/nkT\right)$ where ***ΔV_{VCMA}*** is the difference between *V_{VCMA}* when *R_{VCMA} = R_{AP}* and *R_{VCMA} = R_{P},* respectively. Table 1 shows the values of the biasing current ${I}_{bias}^{′}$*, V_{VCMA}, I_{read}* and the TMR for a read voltage V_{read} *=* 0.8 V, a bias voltage *V_{bias} = V_{read}, R_{P} =* 100 kΩ and *R_{AP} =* 200 kΩ.

**Table 1**

| | **P** | **AP** |
|---|---|---|
| *R_{VCMA}* | 100 kΩ | 200 kΩ |
| TMR₀ | 100% | |
| ${I}_{bias}^{′}$ | 0.59 µA | 0.57 µA |
| *V_{VCMA}* | 205mV | 235mV |
| *I_{Read}* | **1.47 µA** | **0.61 µA** |
| TMR | **140%** | |

Hence, as may be seen, a biasing current may considerably increase the resistance ratio during read.

With reference again to Fig. 4, there is shown a biasing scheme for reading a selected memory cell 103s of a cross point array. In the depicted example, the selected memory cell 103s is the memory cell among the memory cells 103 connected between the first access line WL2 and the second access line BL3. The biasing voltages of the read scheme may be provided by read circuitry 110, 112. The read circuitry 110, 112 may as per se is known in the art comprise word line and bit line drivers, sense amplifier circuits, etc. The read circuitry 110, 112 may be implemented by CMOS circuitry in a manner which per se is known in the art. The active devices of the writing circuitry 110, 112 may be formed on a front side of the substrate 101, below the cross point array.

In the figure, V_{read} denotes the select voltage (or read voltage) applied to the selected first access line WL2, more specifically to its associated metal layer 106 (e.g. the first metal sub-layer 106a). V_{Ref} denotes a reference voltage applied to the selected second access line BL3. The reference voltage V_{Ref} may typically be a ground reference voltage GND (i.e. approximately 0 V). V_{WL-uns} denotes a first un-select voltage applied to non-selected first access lines WL1, WL3, more specifically to its associated metal layer 106 (e.g. the first metal sub-layer 106a). V_{BL-uns} denotes a second un-select voltage applied to non-selected second access lines BL1, BL2, BL4, BL5.

According to the read biasing scheme implemented by the read circuitry 110, 112, the select voltage V_{Read}, the reference voltage V_{Ref} and the first and second un-select voltages V_{WL-uns}, V_{BL-uns} are set such that:
- the selector device 105 of the selected memory cell 103s is forward biased with a voltage exceeding a threshold voltage of the selector device 105,
- the selector devices 105 of non-selected memory cells 103 are either forward biased with a sub-threshold voltage, substantially zero-biased, or reverse biased, and
- a sufficient biasing current I_{bias} flows into the internal node 103i (see Fig. 5) of the selected memory cell 103s from the non-selected second access lines BL1, BL2, BL4, BL5, via the lateral semiconductor channels 108a of the MESFETs connected to the selected memory cell 103s.

In one example implementation, the reference voltage V_{Ref} may correspond to ground (~0 V), the select voltage V_{read} may be a positive voltage exceeding a gate threshold voltage of the MESFETs and the threshold voltage of the selector device 105, the first un-select voltage may be set to V_{WL-uns} ≤ V_{Ref} and the second un-select voltage may be set to V_{BL-uns} ≈ V_{Read}.

By this biasing scheme, the selector device 105 of the selected memory cell 103s may be switched on and forward biased so that a sense current may flow from the selected first access line WL2 into the selected memory cell 103s. Meanwhile, the selector device 105 of non-selected memory cells 103 along the selected first access line WL2, may be either forward biased with a sub-threshold voltage or substantially zero-biased (depending on the voltage drop across the associated ME 104) and hence remain switched off.

If V_{WL-uns} ≈ V_{Ref} the selector device 105 of non-selected memory cells 103 along the non-selected first access lines WL1, WL3, may be reverse biased with a. If V_{WL-uns} < V_{Ref} the selector device 105 of non-selected memory cells 103 along non-selected first access lines WL1, WL3, may be reverse biased even more strongly. Additionally, by setting the first un-select voltage V_{WL-uns} smaller than V_{Ref} the gate voltage of the MESFETs of the non-selected first access lines WL1, WL3 may be negative, thereby increasing the lateral channel resistance *Rₗₐᵣₑᵣₐₗ* along the non-selected first access lines WL1, WL3. This may further suppress lateral sneak currents between memory cells 103 along the non-selected first access lines WL1, WL3 during read.

Additionally, responsive to the second un-select voltage V_{BL-uns} ≈ V_{Read} in combination with the select voltage V_{read} acting as gate voltage for the MESFETs along the selected first access line WL2, a biasing current may be supplied to the internal node 103i of the selected memory cell 103s. As discussed above, the biasing current will typically be dominated by the contribution from the nearest neighboring second access lines BL2 and BL4 to the selected second access line BL3.

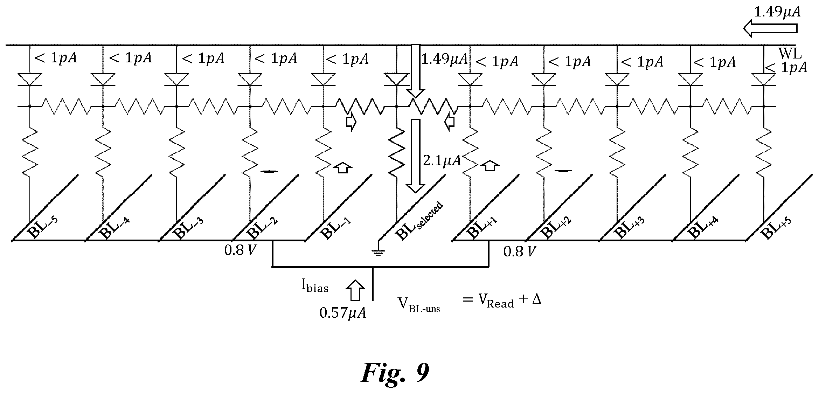

Fig. 9 shows a simulation of currents through a selected memory cell along the first access line WL for an example read biasing scheme for a select voltage V_{Read}. The lateral semiconductor channel is modelled as a fixed resistance *Rₗₐᵣₑᵣₐₗ* = 2 MΩ. The ME of each of the memory cells is assumed to be in the first/low resistance state so that *R_{VCMA} = R_{P} =* 100 kΩ. The resulting biasing current supplied to the internal node 103 of the selected memory cell is as shown 0.57 µA. This gives a sense current of 1.49 µA along the selected first access line. Performing a corresponding simulation for *R_{VCMA}* = *R_{AP}* = 200 kΩ gives a biasing current of 0.54 µA and a sense current of 0.63 µA, which translates to a TMR of about 138 %. Assuming a less favorable condition, wherein the ME of all non-selected memory cells are set to the second/high resistance state, biasing currents and the sense currents for the P and AP states become, respectively, 0.55 µA/0.52 µA and 1.51 µA/0.64 µA, which translates to a TMR of 134%.

From the expression derived for the internal node voltage *V_{VCMA}* for Fig. 8, it may be appreciated that the biasing of a memory cell may be increased by increasing the ratio *R_{VCMA}* / *Rₗₐₜₑᵣₐₗ.* Additionally, the internal node voltage *V_{VCMA}* may be increased by increasing the voltage V_{BL-uns} on the non-selected second access lines. In particular, V_{BL-uns} may as shown in Fig. 9 be increased by Δ over V_{Read}. Consequently, the selector devices of the non-selected memory cells become reverse biased. Hence, the practical limit of Δ is determined by the maximum reverse-bias voltage the selector devices may withstand.

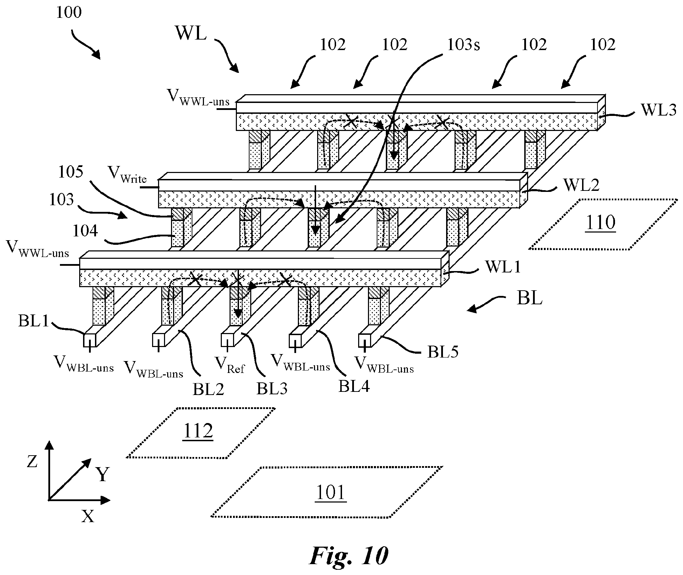

A biasing scheme for implementing a write operation will now be described with reference to Fig. 10. The biasing voltages of the write scheme may be provided by write circuitry, which may be comprised in the same CMOS circuitry as the read circuitry 110, 112 and hence in Fig. 10 is indicated with the same reference signs. The write operation will be described with reference to the same memory cell as the selected memory cell 103s of the read operation, but may of course be applied in a corresponding fashion to any one of the memory cells 103.

In the figure, V_{Write} denotes the write voltage (or program voltage) applied to the selected first access line WL2, more specifically to its associated metal layer 106 (e.g. the first metal sub-layer 106a). V_{Ref} denotes a reference voltage applied to the selected second access line BL3. The reference voltage V_{Ref} may typically be a ground reference voltage GND (i.e. approximately 0 V). V_{WWL-uns} denotes a first write un-select voltage applied to non-selected first access lines WL1, WL3, more specifically to its associated metal layer 106 (e.g. the first metal sub-layer 106a). V_{WBL-uns} denotes a second write un-select voltage applied to non-selected second access lines BL1, BL2, BL4, BL5.

According to the write biasing scheme implemented by the write circuitry 110, 112, the write voltage V_{Write}, the reference voltage V_{Ref} and the first and second write un-select voltages V_{WWL-uns}, V_{WBL-uns} are set such that:
- the selector device 105 of the selected memory cell 103s is forward biased with a voltage exceeding the threshold voltage of the selector device 105,
- the ME 104 of the selected memory cell 103s is biased with a voltage exceeding a resistive state switching threshold voltage of the ME 104, and
- the selector devices 105 of the non-selected memory cells 103 are either forward biased with a sub-threshold voltage, substantially zero-biased, or reverse biased.

In one example implementation, the reference voltage V_{Ref} may correspond to ground (~0 V), the write voltage V_{Write} may be a positive voltage exceeding the resistive state switching threshold voltage of the ME 104 and the threshold voltage of the selector device 105, the first write un-select voltage may be set to V_{WWL-uns} ≤ V_{Ref} and the second un-select voltage may be set to V_{WBL-uns} ≈ V_{Write}.

By this biasing scheme, the selector device 105 of the selected memory cell 103s may be switched on and forward biased so that a write current may flow from the selected first access line WL2 into the selected memory cell 103s and through the ME 104. Meanwhile, the selector device 105 of non-selected memory cells 103 along the selected first access line WL2, may be either forward biased with a sub-threshold voltage or substantially zero-biased (depending on the voltage drop across the associated ME 104) and hence remain switched off.

However, setting V_{WBL-uns} ≈ V_{Write} results in a voltage difference which will drive a leakage current flowing from the second access lines BL2, BL4 into the internal node 103i of the selected memory cell 103s, via the lateral semiconductor channels 108a of the MESFETs (shown in Fig. 5) connected to the internal node 103i. It is however envisaged that the channel resistance *Rₗₐᵣₑᵣₐₗ* of the lateral semiconductor channels of the MESFETs, when gated by a voltage of a level typical for writing resistive memory elements (e.g. by way of example 1-2 V), is comparable to or exceeds the resistance of the resistive memory element during programming, such that the leakage currents may be kept small enough to avoid write disturb. Low leakage is further enabled due to that during Write operation, voltage of the internal node 103i of the selected cell 103s will be substantially increased, resulting in a decrease in voltage drop between source and drain of the MESFET.

Turning to the first write un-selected voltages, if V_{WLL-uns} ≈ V_{Ref} the selector device 105 of the non-selected memory cells 103 along the non-selected first access lines WL1, WL3, may be reverse biased. If V_{WWL-uns} < V_{Ref} the selector device 105 of non-selected memory cells 103 along non-selected first access lines WL1, WL3, may be more strongly reverse biased and hence remain switched off. Additionally, by setting the first un-select voltage V_{WL-uns} smaller than V_{Ref} the gate voltage of the MESFETs of the non-selected first access lines WL1, WL3 may be negative, thereby increasing the lateral channel resistance *Rₗₐᵣₑᵣₐₗ* along the non-selected first access lines WL1, WL3. This may further suppress lateral sneak currents between memory cells 103 along the non-selected first access lines WL1, WL3 during write.

The person skilled in the art realizes that the present invention by no means is limited to the embodiments described above. On the contrary, many modifications and variations are possible within the scope of the appended claims.

## Claims

1. A cross point memory device (100) comprising:
first access lines (WL) and second access lines (BL), the first access lines (WL) extending in a first direction (X) and the second access lines (BL) extending in a second direction (Y) across the first direction to define a plurality of cross points (102) between the first and second access lines (WL, BL); and
a memory cell (103) connected between the first access line (WL) and the second access line (BL) at each cross point (102) and comprising a resistive memory element (104) switchable between a first resistance state and a second resistance state;
wherein each first access line (WL) comprises a metal layer (106) and a semiconductor layer (108) extending continuously in the first direction (X) to define a distributed Schottky diode forming a respective selector device (105) of each memory cell (103), wherein the selector device (105) and the resistive memory element (104) of each memory cell (103) are connected in series between the associated first and second access lines (WL, BL) via an internal node (103i) of the respective memory cell (103); and
wherein the internal nodes of each pair of consecutive memory cells (103) along each respective first access line (WL) are connected by a respective segment (108a) of the semiconductor layer (108) defining a lateral semiconductor channel configured to be gated by the metal layer (106) of its associated first access line (WL);
the memory device further comprising read circuitry (110, 112) configured to read the resistive memory element (104) of a selected memory cell (103s) connected to a selected first access line (WL2) and a selected second access line (BL3) by: applying a select voltage (V_{Read}) to the metal layer (106) of the selected first access line (WL2), a reference voltage (V_{Ref}) to the selected second access line (BL3), a first un-select voltage (V_{WL-uns}) to the metal layer (106) of non-selected first access lines (WL1, WL3), and a second un-select voltage (V_{BL-uns}) to non-selected second access lines (BL1, BL2, BL4, BL5),
wherein the select voltage (V_{Read}), the reference voltage (V_{Ref}) and the first and second un-select voltages (V_{WL-uns}, V_{BL-uns}) are set such that:
the selector device (105) of the selected memory cell (103s) is forward biased with a voltage exceeding a threshold voltage of the selector device (105),
the selector devices (105) of non-selected memory cells (103) are either forward biased with a sub-threshold voltage, substantially zero-biased, or reverse biased, and
a biasing current flows into the internal node of the selected memory cell (103s) from the non-selected second access lines (BL1, BL2, BL4, BL5), via the semiconductor channels (108a) connected to the selected memory cell (103s).

2. The memory device according to claim 1, wherein a gate threshold voltage of each lateral semiconductor channel (108a) is lower than the threshold voltage of the selector devices (105), and wherein the select voltage (V_{Read}), the reference voltage (V_{Ref}) and the first and second un-select voltages (V_{WL-uns}, V_{BL-uns}) are set such that a gate voltage for the lateral semiconductor channels (108a) along the selected first access line (WL2) exceeds the gate threshold voltage and such that a gate voltage for the lateral semiconductor channels (108a) along the non-selected first access lines (WL1, WL3) is less than the gate threshold voltage.

3. The memory device according to any one of the preceding claims, wherein the first resistance state and the second resistance state of the resistive memory elements (104) are respectively associated with a first resistance and a second resistance exceeding the first resistance, and
wherein, responsive to said voltages being applied by the read circuitry (110, 112) during reading of the selected memory cell (103s), each lateral semiconductor channel (108a) connected to the internal node (103i) of the selected memory cell (103s) presents a first channel resistance exceeding the second resistance of the second resistance state, and a channel resistance of each other lateral semiconductor channel (108a) along the selected first access line (WL2) exceeds the first channel resistance.

4. The memory device according to claim 3, wherein the first channel resistance is at least 2 times the second resistance value (R_{AP}).

5. The memory device according to any one of claims 3-4, wherein the first channel resistance is an on-state resistance of the lateral semiconductor channels.

6. The memory device according to any one of the preceding claims, wherein the second un-select voltage (V_{BL-uns}) corresponds to, or is greater than, the select voltage (V_{Read}).

7. The memory device according to any one of the preceding claims, wherein the first un-select voltage (V_{WL-uns}) corresponds to or is lower than the reference voltage (V_{Ref}).

8. The memory device according to any one of the preceding claims, further comprising write circuitry (110, 112) configured to program a resistance state of the resistive memory element (104) of a memory cell (103s) selected for write by: applying a write voltage (V_{Write}) to the respective first access line (WL2) connected to said memory cell (103s), a reference voltage (V_{Ref}) to the respective second access line (BL3) connected to said memory cell (103s), a first write un-select voltage (V_{WWL-uns}) to non-selected first access lines (WL1, WL3) and a second write un-select voltage (V_{WBL-uns}) to non-selected second access lines (BL1, BL2, BL4, BL5),
wherein the write voltage (V_{Write}), the reference voltage (V_{Ref}) and the first and second write un-select voltages (V_{WWL-uns}, V_{WBL-uns}) are set such that: the selector device (105) of said memory cell (103s) selected for write is forward biased with a voltage exceeding the threshold voltage of the selector device (105), the resistive memory element (104) of said memory cell (103s) is biased with a voltage exceeding a resistive state switching threshold voltage of the resistive memory element (104), and the selector devices (105) of non-selected memory cells (103) are either forward biased with a sub-threshold voltage, substantially zero-biased, or reverse biased.

9. The memory device according to claim 8, wherein the second write un-select voltage (WBLᵤₙₛ) corresponds to the write voltage (V_{Write}).

10. The memory device according to claim 9, wherein the first write un-select voltage (WWLᵤₙₛ) corresponds to or is lower than the reference voltage (V_{Ref}).

11. The memory device according to any one the preceding claims, wherein each segment (108a) extends between a pair of electrode contact portions (108b) of the semiconductor layer (108), each electrode contact portions making Ohmic contact with an electrode of a respective resistive memory device (104), wherein a thickness dimension of the electrode contact portions (108b) exceeds a thickness dimension of the segments (108a).

12. The memory device according to any one of the preceding claims, wherein each segment (108a) extends between a pair of electrode contact portions (108b) of the semiconductor layer (108), each electrode contact portion making Ohmic contact with an electrode of a respective resistive memory device (104), wherein a doping concentration of the segments (108a) is lower than a doping concentration of the electrode portions (108b).

13. The memory device according to any one of the preceding claims, wherein the semiconductor layer (108) of each first access line (WL) comprises an oxide semiconductor-layer, such as an IGZO-layer,

14. The memory device according to any one of the preceding claims, wherein the metal layer (106) comprises a continuous first metal sub-layer (106a) and a continuous second metal sub-layer (106a) of a work function metal arranged between the first metal sub-layer (106a) and the semiconductor layer (108) and defining the distributed Schottky diode together with the semiconductor layer (108).

15. The memory device according to any of the preceding claims, wherein each memory device (104) is a unipolar resistive memory element, such as a voltage-controlled magnetic anisotropy resistive memory element or a phase change memory element.

## Patentansprüche

1. Koppelpunktspeichervorrichtung (100), umfassend:
erste Zugriffsleitungen (WL) und zweite Zugriffsleitungen (BL), wobei sich die ersten Zugriffsleitungen (WL) in einer ersten Richtung (X) erstrecken und sich die zweiten Zugriffsleitungen (BL) in einer zweiten Richtung (Y) quer über die erste Richtung erstrecken, um eine Vielzahl von Koppelpunkten (102) zwischen den ersten und zweiten Zugriffsleitungen (WL, BL) zu definieren; und
eine Speicherzelle (103), die zwischen der ersten Zugriffsleitung (WL) und der zweiten Zugriffsleitung (BL) an jedem Koppelpunkt (102) angeschlossen ist und ein Widerstandsspeicherelement (104) umfasst, das zwischen einem ersten Widerstandszustand und einem zweiten Widerstandszustand umschaltbar ist;
wobei jede erste Zugriffsleitung (WL) eine Metallschicht (106) und eine Halbleiterschicht (108) umfasst, die sich durchgehend in der ersten Richtung (X) erstrecken, um eine verteilte Schottky-Diode zu definieren, die eine jeweilige Auswahlvorrichtung (105) jeder Speicherzelle (103) bildet, wobei die Auswahlvorrichtung (105) und das Widerstandsspeicherelement (104) jeder Speicherzelle (103) zwischen den zugeordneten ersten und zweiten Zugriffsleitungen (WL, BL) über einen internen Knoten (103i) der jeweiligen Speicherzelle (103) in Reihe geschaltet sind; und
wobei die internen Knoten jedes Paars von aufeinanderfolgenden Speicherzellen (103) entlang jeder jeweiligen ersten Zugriffsleitung (WL) durch ein jeweiliges Segment (108a) der Halbleiterschicht (108) angeschlossen sind, wobei sie einen seitlichen Halbleiterkanal bilden, der dazu konfiguriert ist, durch die Metallschicht (106) seiner zugeordneten ersten Zugriffsleitung (WL) gate-gesteuert zu werden;
wobei die Speichervorrichtung ferner Leseschaltungen (110, 112) umfasst, die dazu konfiguriert sind, das Widerstandsspeicherelement (104) einer ausgewählten Speicherzelle (103s), die an eine ausgewählte erste Zugriffsleitung (WL2) und eine ausgewählte zweite Zugriffsleitung (BL3) angeschlossen ist, zu lesen durch: Anlegen einer Auswahlspannung (V_{Read}) an die Metallschicht (106) der ausgewählten ersten Zugriffsleitung (WL2), einer Referenzspannung (V_{Ref}) an die ausgewählte zweite Zugriffsleitung (BL3), einer ersten Abwahlspannung (V_{WL-uns}) an die Metallschicht (106) von nicht ausgewählten ersten Zugriffsleitungen (WL1, WL3), und einer zweiten Abwahlspannung (V_{BL-uns}) an nicht ausgewählte zweite Zugriffsleitungen (BL1, BL2, BL4, BL5),
wobei die Auswahlspannung (V_{Read}), die Referenzspannung (V_{Ref}) und die erste und die zweite Abwahlspannung (V_{WL-uns}, V_{BL-uns}) derart eingestellt sind, dass:
die Auswahlvorrichtung (105) der ausgewählten Speicherzelle (103s) mit einer Spannung, die eine Schwellenspannung der Auswahlvorrichtung (105) überschreitet, in Durchlassrichtung vorgespannt ist,
die Auswahlvorrichtungen (105) von nicht ausgewählten Speicherzellen (103) entweder mit einer Unterschwellenspannung in Durchlassrichtung vorgespannt, im Wesentlichen mit null vorgespannt oder in Sperrrichtung vorgespannt sind, und
ein Vorspannstrom in den internen Knoten der ausgewählten Speicherzelle (103s) von den nicht ausgewählten zweiten Zugriffsleitungen (BL1, BL2, BL4, BL5) über die Halbleiterkanäle (108a), die an die ausgewählte Speicherzelle (103s) angeschlossen sind, fließt.

2. Speichervorrichtung nach Anspruch 1, wobei eine Gate-Schwellenspannung jedes seitlichen Halbleiterkanals (108a) niedriger als die Schwellenspannung der Auswahlvorrichtungen (105) ist, und wobei die Auswahlspannung (V_{Read}), die Referenzspannung (V_{Ref}) und die erste und die zweite Abwahlspannung (V_{WL-uns}, V_{BL-uns}) derart eingestellt sind, dass eine Gate-Spannung für die seitlichen Halbleiterkanäle (108a) entlang der ausgewählten ersten Zugriffsleitung (WL2) die Gate-Schwellenspannung überschreitet, und so dass eine Gate-Spannung für die seitlichen Halbleiterkanäle (108a) entlang der nicht ausgewählten ersten Zugriffsleitungen (WL1, WL3) kleiner als die Gate-Schwellenspannung ist.

3. Speichervorrichtung nach einem der vorhergehenden Ansprüche, wobei der erste Widerstandszustand und der zweite Widerstandszustand der Widerstandsspeicherelemente (104) jeweils einem ersten Widerstand und einem zweiten Widerstand, der den ersten Widerstand überschreitet, zugeordnet sind, und
wobei, als Reaktion auf die Spannungen, die von den Leseschaltungen (110, 112) während des Lesens der ausgewählten Speicherzelle (103s) angelegt werden, jeder seitliche Halbleiterkanal (108a), der an den internen Knoten (103i) der ausgewählten Speicherzelle (103s) angeschlossen ist, einen ersten Kanalwiderstand aufweist, der den zweiten Widerstand des zweiten Widerstandszustands überschreitet, und ein Kanalwiderstand jedes anderen seitlichen Halbleiterkanals (108a) entlang der ausgewählten ersten Zugriffsleitung (WL2) den ersten Kanalwiderstand überschreitet.

4. Speichervorrichtung nach Anspruch 3, wobei der erste Kanalwiderstand mindestens zweimal der zweite Widerstandswert (R_{AP}) ist.

5. Speichervorrichtung nach einem der Ansprüche 3 bis 4, wobei der erste Kanalwiderstand ein Einschaltzustandswiderstand der seitlichen Halbleiterkanäle ist.

6. Speichervorrichtung nach einem der vorhergehenden Ansprüche, wobei die zweite Abwahlspannung (V_{BL-uns}) der Auswahlspannung (V_{Read}) entspricht oder größer als diese ist.

7. Speichervorrichtung nach einem der vorhergehenden Ansprüche, wobei die erste Abwahlspannung (V_{WL-uns}) der Referenzspannung (V_{Ref}) entspricht oder kleiner als diese ist.

8. Speichervorrichtung nach einem der vorhergehenden Ansprüche, ferner umfassend Schreibschaltungen (110, 112), die dazu konfiguriert sind, einen Widerstandszustand des Widerstandsspeicherelements (104) einer Speicherzelle (103s), die zum Schreiben ausgewählt wird, zu programmieren durch: Anlegen einer Schreibspannung (V_{Write}) an die jeweilige erste Zugriffsleitung (WL2), die an die Speicherzelle (103s) angeschlossen ist, einer Referenzspannung (V_{Ref}) an die jeweilige zweite Zugriffsleitung (BL3), die an die Speicherzelle (103s) angeschlossen ist, einer ersten Schreib-Abwahlspannung (V_{WWL-uns}) an nicht ausgewählte erste Zugriffsleitungen (WL1, WL3) und einer zweiten Schreib-Abwahlspannung (V_{WBL-uns}) an nicht ausgewählte zweite Zugriffsleitungen (BL1, BL2, BL4, BL5),
wobei die Schreibspannung (V_{Write}), die Referenzspannung (V_{Ref}) und die erste und die zweite Schreib-Abwahlspannung (V_{WWL-uns}, V_{WBL-uns}) derart eingestellt sind, dass: die Auswahlvorrichtung (105) der Speicherzelle (103s), die zum Schreiben ausgewählt ist, mit einer Spannung, welche die Schwellenspannung der Auswahlvorrichtung (105) überschreitet, in Durchlassrichtung vorgespannt ist, das Widerstandsspeicherelement (104) der Speicherzelle (103s) mit einer Spannung vorgespannt ist, die eine Umschaltschwellenspannung eines Widerstandszustands des Widerstandsspeicherelements (104) überschreitet, und die Auswahlvorrichtungen (105) von nicht ausgewählten Speicherzellen (103) entweder mit einer Unterschwellenspannung in Durchlassrichtung vorgespannt, im Wesentlichen mit null vorgespannt oder in Sperrrichtung vorgespannt sind.

9. Speichervorrichtung nach Anspruch 8, wobei die zweite Schreib-Abwahlspannung (W_{BLuns}) der Schreibspannung (V_{Write}) entspricht.

10. Speichervorrichtung nach Anspruch 9, wobei die erste Schreib-Abwahlspannung (WWLᵤₙₛ) der Referenzspannung (V_{Ref}) entspricht oder kleiner als diese ist.

11. Speichervorrichtung nach einem der vorhergehenden Ansprüche, wobei sich jedes Segment (108a) zwischen einem Paar von Elektrodenkontaktabschnitten (108b) der Halbleiterschicht (108) erstreckt, wobei jeder Elektrodenkontaktabschnitt einen ohmschen Kontakt mit einer Elektrode einer jeweiligen Widerstandsspeichervorrichtung (104) herstellt, wobei eine Dickendimension der Elektrodenkontaktabschnitte (108b) eine Dickendimension der Segmente (108a) überschreitet.

12. Speichervorrichtung nach einem der vorhergehenden Ansprüche, wobei sich jedes Segment (108a) zwischen einem Paar von Elektrodenkontaktabschnitten (108b) der Halbleiterschicht (108) erstreckt, wobei jeder Elektrodenkontaktabschnitt einen ohmschen Kontakt mit einer Elektrode einer jeweiligen Widerstandsspeichervorrichtung (104) herstellt, wobei eine Dotierungskonzentration der Segmente (108a) kleiner als eine Dotierungskonzentration der Elektrodenabschnitte (108b) ist.

13. Speichervorrichtung nach einem der vorhergehenden Ansprüche, wobei die Halbleiterschicht (108) jeder ersten Zugriffsleitung (WL) eine Oxidhalbleiterschicht, wie etwa eine IGZO-Schicht, umfasst.

14. Speichervorrichtung nach einem der vorhergehenden Ansprüche, wobei die Metallschicht (106) eine durchgehende erste Metallteilschicht (106a) und eine durchgehende zweite Metallteilschicht (106a) eines Arbeitsfunktionsmetalls umfasst, das zwischen der ersten Metallteilschicht (106a) und der Halbleiterschicht (108) angeordnet ist und die verteilte Schottky-Diode zusammen mit der Halbleiterschicht (108) definiert.

15. Speichervorrichtung nach einem der vorhergehenden Ansprüche, wobei jede Speichervorrichtung (104) ein einpoliges Widerstandsspeicherelement, wie etwa ein spannungsgesteuertes magnetisches anisotropes Widerstandsspeicherelement oder ein phasenänderndes Speicherelement, ist.

## Revendications

1. Dispositif de mémoire à points de croisement (100) comprenant :
des premières lignes d'accès (WL) et des deuxièmes lignes d'accès (BL), les premières lignes d'accès (WL) s'étendant dans une première direction (X) et les deuxièmes lignes d'accès (BL) s'étendant dans une deuxième direction (Y) à travers la première direction pour définir une pluralité de points de croisement (102) entre les premières et deuxièmes lignes d'accès (WL, BL) ; et
une cellule de mémoire (103) connectée entre la première ligne d'accès (WL) et la deuxième ligne d'accès (BL) à chaque point de croisement (102) et comprenant un élément de mémoire résistif (104) commutable entre un premier état de résistance et un deuxième état de résistance ;
dans lequel chaque première ligne d'accès (WL) comprend une couche métallique (106) et une couche semi-conductrice (108) s'étendant de manière continue dans la première direction (X) pour définir une diode Schottky répartie formant un dispositif de sélection respectif (105) de chaque cellule de mémoire (103), dans lequel le dispositif de sélection (105) et l'élément de mémoire résistif (104) de chaque cellule de mémoire (103) sont connectés en série entre les premières et deuxièmes lignes d'accès associées (WL, BL) via un nœud interne (103i) de la cellule de mémoire respective (103) ; et
dans lequel les nœuds internes de chaque paire de cellules de mémoire consécutives (103) le long de chaque première ligne d'accès respective (WL) sont connectés par un segment respectif (108a) de la couche semi-conductrice (108) définissant un canal semi-conducteur latéral configuré pour être commandé par effet de champ par la couche métallique (106) de sa première ligne d'accès associée (WL) ;
le dispositif de mémoire comprenant en outre des circuits de lecture (110, 112) configurés pour lire l'élément de mémoire résistif (104) d'une cellule de mémoire sélectionnée (103s) connectée à une première ligne d'accès sélectionnée (WL2) et à une deuxième ligne d'accès sélectionnée (BL3) en : appliquant une tension de sélection (V_{Read}) à la couche métallique (106) de la première ligne d'accès sélectionnée (WL2), une tension de référence (V_{Ref}) à la deuxième ligne d'accès sélectionnée (BL3), une première tension de non-sélection (V_{WL-uns}) à la couche métallique (106) des premières lignes d'accès non sélectionnées (WL1, WL3) et une deuxième tension de non-sélection (V_{BL-uns}) aux deuxièmes lignes d'accès non sélectionnées (BL1, BL2, BL4, BL5),
dans lequel la tension de sélection (V_{Read}), la tension de référence (V_{Ref}) et les première et deuxième tensions de non-sélection (V_{WL-uns}, V_{BL-uns}) sont réglées de telle sorte que :
le dispositif de sélection (105) de la cellule de mémoire sélectionnée (103s) est polarisé en sens direct avec une tension dépassant une tension de seuil du dispositif de sélection (105),
les dispositifs de sélection (105) des cellules de mémoire non sélectionnées (103) sont soit polarisés en sens direct avec une tension inférieure au seuil, soit polarisés à une tension sensiblement nulle, soit polarisés en sens inverse et
un courant de polarisation circule vers le nœud interne de la cellule de mémoire sélectionnée (103s) depuis les deuxièmes lignes d'accès non sélectionnées (BL1, BL2, BL4, BL5), via les canaux semi-conducteurs (108a) connectés à la cellule de mémoire sélectionnée (103s).

2. Dispositif de mémoire selon la revendication 1, dans lequel une tension de seuil de grille de chaque canal semi-conducteur latéral (108a) est inférieure à la tension de seuil des dispositifs de sélection (105) et dans lequel la tension de sélection (V_{Read}), la tension de référence (V_{Ref}) et les première et deuxième tensions de non-sélection (V_{WL-uns}, V_{BL-uns}) sont réglées de telle sorte qu'une tension de grille pour les canaux semi-conducteurs latéraux (108a) le long de la première ligne d'accès sélectionnée (WL2) dépasse la tension de seuil de grille et de telle sorte qu'une tension de grille pour les canaux semi-conducteurs latéraux (108a) le long des premières lignes d'accès non sélectionnées (WL1, WL3) soit inférieure à la tension de seuil de grille.

3. Dispositif de mémoire selon une quelconque des revendications précédentes, dans lequel le premier état de résistance et le deuxième état de résistance des éléments de mémoire résistifs (104) sont respectivement associés à une première résistance et à une deuxième résistance dépassant la première résistance et
dans lequel, en réponse à l'application desdites tensions par les circuits de lecture (110, 112) pendant la lecture de la cellule de mémoire sélectionnée (103s), chaque canal semi-conducteur latéral (108a) connecté au nœud interne (103i) de la cellule de mémoire sélectionnée (103s) présente une première résistance de canal dépassant la deuxième résistance du deuxième état de résistance et une résistance de canal de chaque autre canal semi-conducteur latéral (108a) le long de la première ligne d'accès sélectionnée (WL2) dépasse la première résistance de canal.

4. Dispositif de mémoire selon la revendication 3, dans lequel la première résistance de canal est au moins le double de la valeur de la deuxième résistance (R_{AP}).

5. Dispositif de mémoire selon une quelconque des revendications 3-4, dans lequel la première résistance de canal est une résistance à l'état passant des canaux semi-conducteurs latéraux.

6. Dispositif de mémoire selon une quelconque des revendications précédentes, dans lequel la deuxième tension de non-sélection (V_{BL-uns}) correspond à, ou est supérieure à, la tension de sélection (V_{Read}).

7. Dispositif de mémoire selon une quelconque des revendications précédentes, dans lequel la première tension de non-sélection (V_{WL-uns}) correspond à, ou est inférieure à, la tension de référence (V_{Ref})

8. Dispositif de mémoire selon une quelconque des revendications précédentes, comprenant en outre des circuits d'écriture (110, 112) configurés pour programmer un état de résistance de l'élément de mémoire résistif (104) d'une cellule de mémoire (103s) sélectionnée pour une écriture en : appliquant une tension d'écriture (V_{Write}) à la première ligne d'accès respective (WL2) connectée à ladite cellule de mémoire (103s), une tension de référence (V_{Ref}) à la deuxième ligne d'accès respective (BL3) connectée à ladite cellule de mémoire (103s), une première tension de non-sélection en écriture (V_{WWL-uns}) aux premières lignes d'accès non sélectionnées (WL1, WL3) et une deuxième tension de non-sélection en écriture (V_{WBL-uns}) aux deuxièmes lignes d'accès non sélectionnées (BL1, BL2, BL4, BL5),
dans lequel la tension d'écriture (V_{Write}), la tension de référence (V_{Ref}) et les première et deuxième tensions de non-sélection en écriture (V_{WWL-uns}, V_{WBL-uns}) sont réglées de telle sorte que : le dispositif de sélection (105) de ladite cellule de mémoire (103s) sélectionnée pour une écriture est polarisé en sens direct avec une tension dépassant la tension de seuil du dispositif de sélection (105), l'élément de mémoire résistif (104) de ladite cellule de mémoire (103s) est polarisé avec une tension dépassant une tension de seuil de commutation d'état résistif de l'élément de mémoire résistif (104) et les dispositifs de sélection (105) des cellules de mémoire non sélectionnées (103) sont soit polarisés en sens direct avec une tension inférieure au seuil, soit polarisés à une tension sensiblement nulle, soit polarisés en sens inverse.

9. Dispositif de mémoire selon la revendication 8, dans lequel la deuxième tension de non-sélection en écriture (WBLᵤₙₛ) correspond à la tension d'écriture (V_{write}).

10. Dispositif de mémoire selon la revendication 9, dans lequel la première tension de non-sélection en écriture (WWLᵤₙₛ) correspond à, ou est inférieure à, la tension de référence (V_{Ref}).

11. Dispositif de mémoire selon une quelconque des revendications précédentes, dans lequel chaque segment (108a) s'étend entre une paire de parties de contact d'électrode (108b) de la couche semi-conductrice (108), chaque partie de contact d'électrode établissant un contact ohmique avec une électrode d'un dispositif de mémoire résistive respectif (104), dans lequel une dimension d'épaisseur des parties de contact d'électrode (108b) est supérieure à une dimension d'épaisseur des segments (108a).

12. Dispositif de mémoire selon une quelconque des revendications précédentes, dans lequel chaque segment (108a) s'étend entre une paire de parties de contact d'électrode (108b) de la couche semi-conductrice (108), chaque partie de contact d'électrode établissant un contact ohmique avec une électrode d'un dispositif de mémoire résistive respectif (104), dans lequel une concentration de dopage des segments (108a) est inférieure à une concentration de dopage des parties de contact d'électrode (108b).

13. Dispositif de mémoire selon une quelconque des revendications précédentes, dans lequel la couche semi-conductrice (108) de chaque première ligne d'accès (WL) comprend une couche de semi-conducteur à base d'oxyde, telle qu'une couche d'IGZO.

14. Dispositif de mémoire selon une quelconque des revendications précédentes, dans lequel la couche métallique (106) comprend une première sous-couche métallique continue (106a) et une deuxième sous-couche métallique continue (106a) constituée d'un métal à fonction de travail spécifique, disposée entre la première sous-couche métallique (106a) et la couche semi-conductrice (108) et définissant la diode Schottky répartie, conjointement à la couche semi-conductrice (108).

15. Dispositif de mémoire selon une quelconque des revendications précédentes, dans lequel chaque dispositif de mémoire (104) est un élément de mémoire résistive unipolaire, tel qu'un élément de mémoire résistive à anisotropie magnétique contrôlée par tension ou un élément de mémoire à changement de phase.
